# EUROPEAN PATENT SPECIFICATION

(11) **EP 2 659 203 B1**
(45) Date of publication and mention of the grant of the patent: **19.02.2020**
(21) Application number: 11853698.6
(22) Date of filing: 29.12.2011
(51) Int. Cl.: F25D 11/00, F25D 19/00

(54) **COLD WATER TANK AND WATER TREATMENT APPARATUS HAVING THE SAME**
KALTWASSERBEHÄLTER UND WASSERBEHANDLUNGSVORRICHTUNG DAMIT
RÉSERVOIR D'EAU FROIDE ET APPAREIL DE TRAITEMENT D'EAU PRÉSENTANT LEDIT RÉSERVOIR

(30) Priority: 29.12.2010 KR 20100137642; 01.09.2011 KR 20110088719
(43) Date of publication of application: 06.11.2013
(73) Proprietor: Coway Co., Ltd., Chungcheongnam-do 314-895 (KR)
(72) Inventor: KIM, Jae-Man, Seoul 151-185 (KR); CHOI, In-Du, Seoul 151-185 (KR); JUNG, Woong, Seoul 151-185 (KR); MOON, Hyun-Seok, Seoul 151-185 (KR); KIM, Kyu-Jun, Seoul 151-185 (KR); LEE, Soo-Yeun, Seoul 151-185 (KR); JOO, Woo-Jin, Seoul 151-185 (KR)
(74) Representative: Nederlandsch Octrooibureau
(86) International application number: PCT/KR2011/010327
(87) International publication number: WO 2012/091499

(56) References cited:
- WO-A1-95/33165
- WO-A1-98/42616
- JP-A- 8 200 920
- JP-A- H08 178 470
- JP-U- H01 142 631
- KR-A- 20020 021 228
- KR-A- 20100 085 531
- KR-B1- 100 836 717
- KR-Y1- 200 288 737
- US-A- 3 248 011

## Description

### Technical Field

The present invention relates to a cold water tank and a water treatment apparatus having the same, and more particularly, to a cold water tank cooled by a cooling unit using a thermoelectric module and a water treatment apparatus capable of cooling a power supply device provided to cool the cold water tank without using an air blowing member.

A water treatment apparatus may be used for various purposes such as processing wastewater or top water (or tap water), producing ultra-pure water, or the like, and the water treatment apparatus of the present invention particularly relates to a water treatment apparatus used for the purpose of providing drinking water. The water treatment apparatus for the purpose of providing drinking water receives raw water (i.e., top water) and filters it to produce clean water, so it is also generally called a water purifier in a narrow sense. Such a water purifier is configured to receive raw water (or top water), filter it by means of a filtration unit, and provide clean water (or purified water) at room temperature to a user. The water purifier may also be configured to heat or cool room temperature purified water to provide warm and/or cold water to the user.

Among water treatment apparatuses for the purpose of providing drinking water, there is provided a functional water purifier that provides various types of functional water such as ionized water, carbonated water, and oxygenized water. Additionally, the water treatment apparatus which primarily filters water supplied from a water supply means such as a water container, or the like, may include a water heater, a water cooler, an ice maker, and the like, to heat or cool the filtered water or generate ice. In consideration of this, in the present disclosure, the term water treatment apparatus is used to generally refer to a water purifier, a functional water purifier, a water heater, a water cooler, an ice maker, as mentioned, and a device having multifunctionality, including at least some of the functions of these devices. A general water purifier (including a water ionizer) may be taken as an example for the sake of explanation, but such a water purifier should be understood as exemplifying the water treatment apparatus according to an embodiment of the present invention.

### Background Art

A cold water tank is a device for cooling water introduced thereto to supply cold water to users. The cold water tank may include a tank main body to which water is introduced and stored and a cooling unit for cooling water stored in the tank main body.

The related art tank main body is made of metal overall. Thus, it is not easy to fabricate the tank main body and a large amount of fabrication costs may be incurred. Also, it may not easy to fabricate a tank main body having a complex shape.

Meanwhile, in the related art cooling unit, an evaporator in which a refrigerant, heat-exchanging with water stored in the tank main body, flows, is installed within or outside the tank main body. However, the use of the cooling system including the evaporator, having a complicated structure, takes up a large amount of space.

In order to solve such problems, a technique of configuring a cooling unit to cool water stored in a tank main body by using a thermoelectric module has been proposed.

In the case of an electronic cooling scheme using a thermoelectric module, one side of the thermoelectric module is in contact with a cold sink connected to a cold water tank and the other side of the thermoelectric module is in contact with a heat sink having a fan. According to this configuration, when the thermoelectric module is driven, heat is transferred from water accommodated in the cold water tank to one side of the thermoelectric module through the cold sink, and the heat, transferred to the one side of the thermoelectric module, is transferred to the heat sink through the other side of the thermoelectric module. The heat, transferred to the heat sink, is transferred to air introduced to the heat sink from the outside, according to the driving of a fan, so as to be dissipated.

However, the cooling unit using the thermoelectric module has a cooling efficiency inferior to that of a cooling system using an evaporator. In addition, when the cooling unit including the thermoelectric module is attached to the tank main body, heat transmission efficiency is degraded.

In addition, in the electronic cooling scheme using the thermoelectric module, cooling is performed by supplying power to the thermoelectric module, requiring a great amount of power, which results in the generation of a large amount of heat from the power supply device. Thus, the related art requires a separate cooling means, such as a fan, or the like, to cool the power supply device. This may make it difficult to reduce the size of the water treatment apparatus such as a water purifier, or the like. In addition, since additional power is required to drive the additional cooling means for cooling the power supply device, energy efficiency of the water treatment apparatus such as a water purifier, or the like, is degraded.

Meanwhile, when water introduced into the cold water tank is rapidly mixed with water already accommodated in the cold water tank, a mixture of recently introduced room temperature water and previously accommodated water having a low temperature may be output to be supplied to a user.

In particular, the cold water tank cools water to have a temperature required to be output to be supplied to a user, but when water (room temperature water) introduced into the cold water tank is rapidly mixed with the water (cold water) already accommodated therein, cold water cannot be output to be supplied and water formed as the cold water is mixed with the room temperature water, having a higher temperature, is output to be supplied. Thus, in order to address this problem, a structure in which water is output from a lower side of the cold water tank by using the specific gravity of water, according to temperature thereof, is adopted, but it has a problem in which it is difficult to stably extract cold water due to water mixture according to a flow rate (or a drop) of room temperature water being introduced to the cold water tank, and water mixture due to a convection current.

In particular, in the case of a direct type cold water tank, when cold water is extracted therefrom, room temperature water is continuously supplied thereto. Thus, in a case in which a large amount of cold water is extracted from a cold water tank, a considerable amount of cold water accommodated in the cold water tank and room temperature water newly introduced thereto are mixed, and thus, after extracting a certain amount of cold water, in actuality, it is difficult to extract cold water having a pre-set temperature or lower.

Also, in the case of the related art direct type cold water tank, water accommodated within the tank main body is output by the pressure of water being introduced, so the interior of the tank main body is under pressure. However, when water is newly supplied to an empty tank main body or when the interior of the tank main body contains air of a certain volume or greater, due to air bubbles, or the like, included in water, the pressure within the tank main body is increased, keeping water from being smoothly supplied to the interior of the tank main body.

In US 3,248,011, a vessel accommodating water is covered by a cover, and a thermoelectric module is connected to one side of the vessel to cool water accommodated in the vessel. A metallic container surrounds the vessel to support the vessel, a rear plate included in the metallic container contacts the thermoelectric module, the vessel is made from stainless steels having relatively good heat conductivity, and the rear plate is made from coppers or aluminums having relatively good heat conductivity.

In WO 95/33165 A1, a thermal barrier assembly is inserted into a main tank to form a lower chamber surrounded by a portion of the main tank and an upper chamber surrounded by the thermal barrier assembly. A thermoelectric chilling assembly includes a thermoelectric module connected to the main tank to cool water stored in the lower chamber, and the main tank is made of two different kinds of material.

In JP H08/178470 A, a bath is covered by a cover, a cooling unit includes a thermoelectric module to cool water stored in the bath. A heat transfer spacer is provided on the lower portion of the bath, and the lower portion of the bath is made of two different kinds of material.

In JP H01/142631 U, an upper portion of a flower base main body is opened, and a thermoelectric module is connected to the flower base main body to cool water in the flower base main body. A heat transfer plate is provided on the bottom of the flower base main body.

In WO 98/42616 A1 also a cold water tank is disclosed, but no components comparable to the second body with a central portion higher than the circumference thereof.

### DISCLOSURE OF INVENTION

### TECHNICAL PROBLEM

The present invention is based upon recognition of at least one of the requirements or problems generated in the related art cold water tank as mentioned above.

An aspect of the present invention provides a cold water tank capable of enhancing cooling efficiency of water accommodated within a tank main body through cooling water via a cooling unit including a thermoelectric module, and a water treatment apparatus having the same.

An aspect of the present invention also provides a cold water tank capable of minimizing heat transmission to the outside through a tank main body, and a water treatment apparatus having the same.

An aspect of the present invention also provides a cold water tank capable of allowing a cooling unit including a thermoelectric module to be easily installed in a tank main body, and a water treatment apparatus having the same.

An aspect of the present invention also provides a cold water tank capable of stably outputting stored water (cold water) accommodated in a tank main body of a cold water tank by preventing introduced water introduced into the tank main body from being rapidly mixed with the stored water, and a water treatment apparatus having the same.

An aspect of the present invention also provides a cold water tank capable of easily implementing a structure in which the mixing of introduced water (room temperature water) and stored water (cold water) is retarded, and a water treatment apparatus having the same.

An aspect of the present invention also provides a cold water tank capable of allowing introduced water to be sufficiently cooled by a cooling unit and then output, and a water treatment apparatus having the same.

An aspect of the present invention also provides a cold water tank capable of maximizing cooling efficiency, and a water treatment apparatus having the same.

An aspect of the present invention also provides a cold water tank in which, when air is introduced into a tank main body, air is discharged, thereby releasing air pressure within the tank main body, thus allowing water to be smoothly introduced thereto, and a water treatment apparatus having the same.

An aspect of the present invention also provides a cold water tank in which a check valve is automatically shut by internal pressure of a tank main body which increases according to water introduced thereinto, to thus allow water to flow into or out of the tank main body via a simple structure, and a water treatment apparatus having the same.

An aspect of the present invention also provides a water treatment apparatus capable of cooling a power supply device, which supplies power to an electronic cooling unit, by using at least a certain amount of air which has cooled a thermoelectric module included in the electronic cooling unit, without using an additional cooling means, whereby the water treatment apparatus can reduce the size of a product and enhance energy efficiency.

### Solution to Problem

According to an aspect of the present invention, there is provided a cold water tank including: a tank main body including a first body and a second body combined to form an internal space therein; and a cooling unit including a thermoelectric module cooling water accommodated within the tank main body.

According to the invention, the first body is made of a synthetic resin material. The second main body is made of a metallic material. The second body has a cladding structure in which heterogeneous metals are joined. In this case, the interior of the second body is made of stainless steel and the exterior thereof is made of aluminum or copper.

The second body has a rounded shape with a central portion higher than the circumference thereof. The second body may have a flat central portion and curved circumference.

Preferably, the first body and the second body may be sealed by a sealing member.

Also, preferably, the thermoelectric module may be connected to the second body to cool the second body.

Here, the cooling unit may include: a cold sink having one side connected to the other side of the second body and the other side in contact with one side of the thermoelectric module; and a heat sink having one side in contact with the other side of the thermoelectric module. The cold sink may be fixed to the second body by a connection member positioned at one side of the second body.

Preferably, a thermally conductive member made of a metallic material may be installed at one side of the second body and accommodated in the internal space of the tank main body. Here, the thermally conductive member may be fixed to the second body by a connection member positioned at one side of the second body. More preferably, the connection member may connect the thermally conductive member, the second body, and the cold sink. The cold sink and the connection member may be fastened by a bolt or a screw.

Also, a fan may be provided in the heat sink. A water inlet unit and a water outlet unit may be formed in the first body.

Preferably, the cooling unit may be attached to the second body by a plurality of fastening members attached to the outer side of the second body.

Also, preferably, a thermally conductive grease may be positioned between the second body and the cold sink. The thermally conductive grease may be positioned at least between the cold sink and the thermoelectric module or between the thermoelectric module and the heat sink.

Preferably, the fastening members may be attached to the second body through spot welding, brazing, or laser welding.

Meanwhile, the tank main body may include an air discharge check valve discharging air within the tank main body to the outside to facilitate an introduction of water into the tank main body, and shut by the pressure within the tank main body when water is introduced into the tank main body.

In another aspect, the cold water tank according to an embodiment of the invention may further include an introduced water stabilization unit provided on the tank main body to prevent introduced water introduced from the water inlet unit from being rapidly mixed with stored water accommodated within the tank main body.

Preferably, the introduced water stabilization unit may include a partition member partitioning an introduced water space to which introduced water is introduced and a stored water space in which stored water is accommodated, and having a communication opening allowing the introduced water space and the stored water space to communicate therethrough. More preferably, the introduced water stabilization unit may further include a mixing retarding plate installed in the introduced water space to allow introduced water introduced through the water inlet unit to collide therewith.

In another embodiment, the introduced water stabilization unit may include: a mixing retarding plate primarily retarding mixing of the introduced water introduced from the water inlet unit with the stored water already accommodated in the tank main body; and a partition member secondarily retarding mixing of water that passes through the mixing retarding plate with the stored water already accommodated in the tank main body and having a communication opening allowing the introduced water to be mixed with the stored water.

Preferably, the mixing retarding plate may have a shape such that a central portion thereof positioned below the water inlet provided in the water inlet unit is bent downwardly.

Also, preferably, the water inlet provided in the water inlet unit and the communication opening may be positioned at the mutually opposed sides of the tank main body based on a thicknesswise direction thereof.

More preferably, the communication opening may be installed at an upper edge of the partition member.

Preferably, the partition member may be formed on the first body, and the introduced water space and the stored water space may be formed as the first body and the second body are combined. Here, a sealing member may be provided between the partition member and the second body to block a flow of water through portions other than the communication opening.

Also, preferably, the communication opening of the partition member may be positioned in an upper part of the portion to which the thermoelectric module is coupled, to allow introduced water to flow to the portion to which the thermoelectric module is coupled through the communication opening. Here, the cooling unit may include a thermally conductive member made of a metallic material and positioned within the tank main body to transfer heat transferred from the cold sink in contact with the thermoelectric module to water accommodated within the tank main body, and the communication opening of the partition member may be positioned in an upper part of the thermally conductive member.

Meanwhile, the tank main body may include the water inlet unit and the water outlet unit, and the water inlet unit may include a buffer space temporarily storing water introduced from the outside before the water is introduced to the tank main body through the water inlet.

Preferably, the buffer space may communicate with a water inlet pipe at a position which deviates from a directly overhead position of the water inlet provided in the water inlet unit.

Also, preferably, the water inlet may include a plurality of openings.

Preferably, a water outlet insulation member may be installed on an outer surface of the tank main body positioned between the water inlet unit and the water outlet unit in order to limit heat transmission between the water inlet unit and the water outlet unit.

According to another aspect of the present invention, there is provided a water treatment apparatus including: the foregoing cold water tank; and a water outlet member extracting water accommodated in the cold water tank.

Also, the water treatment apparatus may further include a power supply device electrically connected to a cooling unit of the cold water tank, wherein at least a certain amount of air that cools a thermoelectric module provided in the cooling unit of the cold water tank flows to the power supply device to cool the power supply device.

Here, the cooling unit provided in the cold water tank may include: a cold sink connected to one side of the thermoelectric module; a heat sink connected to the other side of the thermoelectric module; and a fan installed in the heat sink and allowing external air to be introduced into the heat sink to cool the thermoelectric module and then flow out therefrom.

Preferably, the power supply device may be positioned at an air outflow side of the heat sink so as to be directly cooled by air flowing out from the heat sink.

More preferably, air introduced into the heat sink may flow out from both sides of the heat sink, and the power supply device may be positioned at either side of the heat sink. Here, a plurality of air inflow/outflow holes allowing air to flow in and out therethrough may be formed on the power supply device, and the air inflow/outflow holes of the power supply device may be positioned to face either side of the heat sink.

In another embodiment, an air guide unit may be provided between the heat sink and the power supply device to guide at least a portion of air flowing out from the heat sink to flow to and cool the power supply device.

Preferably, one side of the air guide unit may be positioned at the air outflow side of the heat sink and the other side thereof may be positioned at the power supply device.

More preferably, air introduced into the heat sink may flow out from both sides of the heat sink, and one side of the air guide unit may be positioned at one of both sides of the heat sink. Here, the other side of the air guide unit may be positioned at the plurality of air inflow/outflow holes formed on the power supply device.

Preferably, one side of the air guide unit may have a sectional area larger than that of the other side of the air guide unit.

Also, preferably, the air guide unit may be configured as a duct. Here, one side of the duct may be opened and form an air flow path with a device in which the power supply device is installed.

Preferably, the power supply device may be positioned in an upper part of the cooling unit.

Meanwhile, the power supply device may be configured as a switched-mode power supply (SMPS).

### Advantageous Effects of Invention

According to an embodiment of the present invention, since a first body of the tank main body of the cold water tank, to which water is introduced to be stored, is made of a synthetic resin, the tank main body can be easily fabricated and fabrication cost can be reduced.

Also, according to an embodiment of the present invention, since a thermoelectric module is installed in a second body made of a metallic material to cool water stored in the tank main body of the cold water tank, cooling efficiency and assembly characteristics can be enhanced. In particular, since a thermally conductive member made of a metallic material is installed within the tank main body, cooling efficiency can be enhanced. In addition, since a connection member made of a synthetic resin material is used to couple the thermally conductive member to the first body and a fastening member is not exposed from the connection member, thus preventing the fastening member from corroding.

Also, according to an embodiment of the present invention, since the thermoelectric module is installed in the second main body, water stored in the tank main body of the cold water tank can be effectively cooled by a simple structure through coupling the first and second bodies.

Also, according to an embodiment of the present invention, since the tank main body is formed by the first and second bodies and the cooling unit made of a metallic material is connected to the second body, cooling efficiency and assembly efficiency can be enhanced. Also, since the first body is made of a synthetic resin material, heat-exchange through the first body can be effectively prevented, thus maximizing an insulation effect.

Also, according to an embodiment of the present invention, in case in which the second body to which the cooling unit having the thermoelectric module is coupled is formed to have a cladding structure in which heterogeneous metals are joined, an outer side (outer surface) of the second body is made of a material, such as aluminum (Al) or copper (Cu), having excellent thermal conductivity and an inner side (inner surface) thereof is made of a material, such as stainless steel, or the like, which is stable to water, thereby simultaneously achieving a cooling effect and stably accommodating water.

Also, according to an embodiment of the present invention, since introduced water (room temperature water) introduced into the tank main body of the cold water tank, in a state of being stabilized by an introduced water stabilization unit, is mixed with stored water (cold water) and prevented from being rapidly mixed with the stored water accommodated within the tank main body, whereby stored water (cold water) accommodated in the tank main body can be stably output. In particular, a partition member constituting the introduced water stabilization unit partitions an introduced water space and a stored water space to thereby retard mixing of stored water and introduced water. Also, since the introduced water stabilization unit is comprised of a mixing retarding plate and the partition member, introduced water and stored water can be prevented from being rapidly mixed. In particular, the speed of introduced water is reduced through the mixing retarding plate to prevent introduced water from being rapidly mixed, and the speed of introduced water is lowered through the partition member to allow stabilized introduced water to be gradually mixed with stored water. In addition, since a buffer space is installed at a water inlet unit or the water inlet unit is configured as a plurality of openings, water introduced into the tank main body can be supplied in a state of being stabilized.

In particular, in case of a direct type cold water tank, when stored water (cold water) is extracted, introduced water (room temperature water) is continuously supplied, but in this case, the introduced water and the stored water can be effectively prevented from being rapidly mixed by the introduced water stabilization unit according to an embodiment of the present invention.

Also, according to an embodiment of the present invention, since the first body and the second body are separately configured, the introduced water stabilization unit retarding mixing of introduced water and stored water or stabilizing a flow of introduced water can be easily installed.

Also, according to an embodiment of the present invention, since introduced water (room temperature water) mixed with stored water (cold water) are cooled by the cooling unit through a communication opening of the partition member, the structure for sufficiently cooling introduced water can be implemented. In particular, when a thermally conductive member transferring cooling heat of the thermoelectric module is installed within the tank main body, since introduced water introduced into the space of stored water is supplied to above the thermally conductive member through the communication opening of the partition member, introduced water can be effectively cooled.

Also, according to an embodiment of the present invention, when air is introduced into the tank main body, air is discharged through the check valve, releasing air pressure within the tank main body, thus allow water to be smoothly introduced thereto.

Also, according to an embodiment of the present invention, since the check valve is configured to be automatically shut by the pressure within the tank main body which is increased according to introduced of water, water can smoothly flow into or out of the tank main body in the simple structure.

Also, according to an embodiment of the present invention, since the power supply device supplying power to the electronic cooling unit is cooled by using at least a certain amount of air which has cooled the thermoelectric module included in the cooling unit, the power cooling device can be cooled without using any additional cooling means, and thus, the water treatment apparatus can be reduced in size and energy efficiency thereof can be enhanced.

### Brief Description of Drawings

FIG. 1 is a perspective view of a cold air tank according to an embodiment of the present invention.
FIG. 2 is an exploded perspective view of the cold water tank illustrated in FIG. 1.
FIG. 3 is a rear view of a first body of a tank main body illustrated in FIGS. 1 and 2.
FIG. 4 is an enlarged view of a left upper portion in FIG. 3.
FIG. 5 is an exploded perspective view showing the interior of the first body of the tank main body illustrated in FIGS. 1 and 2.
FIG. 6 is a partially cut perspective view showing an internal configuration of the first body of the tank main body illustrated in FIG. 2.
FIG. 7 is a partially cut perspective view of the cold water tank illustrated in FIG. 1.
FIG. 8 is a partially cut perspective view of a cold water tank according to another embodiment of the present invention.
FIG. 9 is a perspective view of a cold water tank according to a non-claimed example.
FIG. 10 is a perspective view showing an internal configuration of the cold water tank illustrated in FIG. 9.
FIG. 11 is a vertical sectional view of the cold water tank illustrated in FIG. 9.
FIG. 12 is a cross-sectional view showing a connection structure of a second body and a cooling unit according to another embodiment of the present invention.
FIG. 13 is an exploded cross-sectional view of the connection structure of the second body and the cooling unit illustrated in FIG. 12.
FIG. 14 is a cross-sectional view showing a connection structure of a second body and a cooling unit according to another embodiment of the present invention.
FIG. 15 is an exploded cross-sectional view of the connection structure of the second body and the cooling unit illustrated in FIG. 12.
FIG. 16 is a perspective view showing an example of a check value, which is used for discharging air, provided in the cold water tank according to an embodiment of the present invention.
FIG. 17 is an exploded perspective view of the check valve used for discharging air in FIG. 16.
FIGS. 18 and 19 are views showing an operational state of the check valve used for discharging air illustrated in FIGS. 16 and 17, respectively.
FIG. 20 is a perspective view showing an internal structure of a water treatment apparatus according to an embodiment of the present invention.
FIG. 21 is a perspective view showing an internal structure of a water treatment apparatus according to another embodiment of the present invention.

### Best Mode for Carrying out the Invention

Hereinafter, a cold water tank related to an embodiment of the present invention will be described in detail to help understand the features of the present invention.

Hereinafter, embodiments most appropriate to help in an understanding of the technical features of the present invention will be described, the technical features of the present invention are not limited by the described embodiments and merely illustrate the implementation of the present invention through the embodiments described hereinafter. Thus, the present invention can be variably modified within the scope of the present invention through the embodiments described below, and such modifications are within the scope of the present invention. In order to help understand the embodiments described hereinafter, the like or similar reference numerals are used for relevant components among the components having the same function in the respective embodiments in the accompanying drawings.

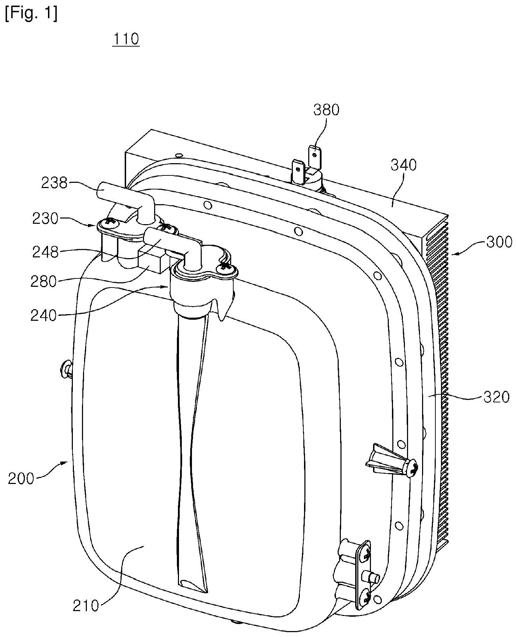

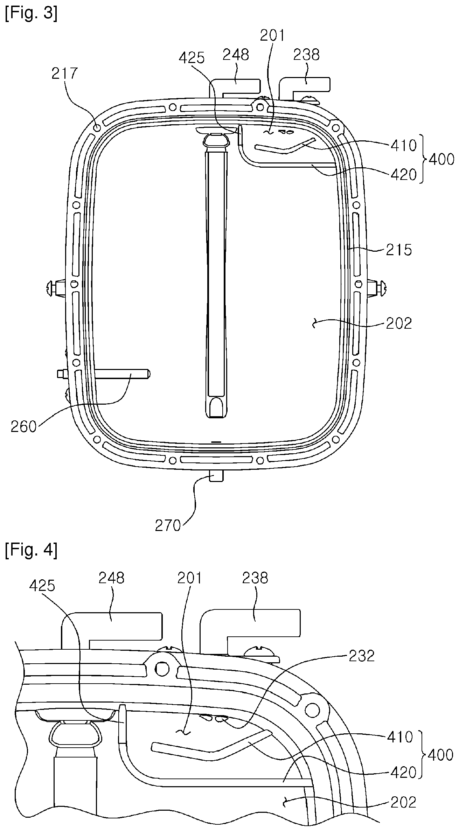

First, a cold water tank 110 according to an embodiment of the present invention will be described with reference to FIGS. 1 through 19.

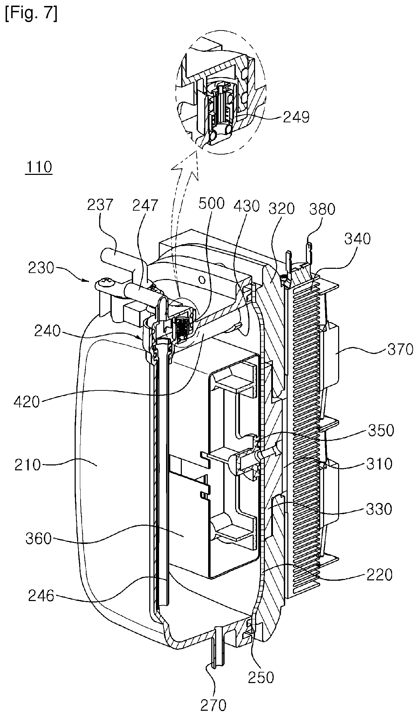

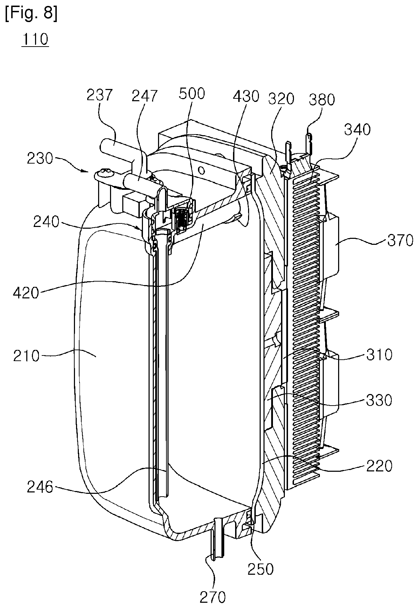

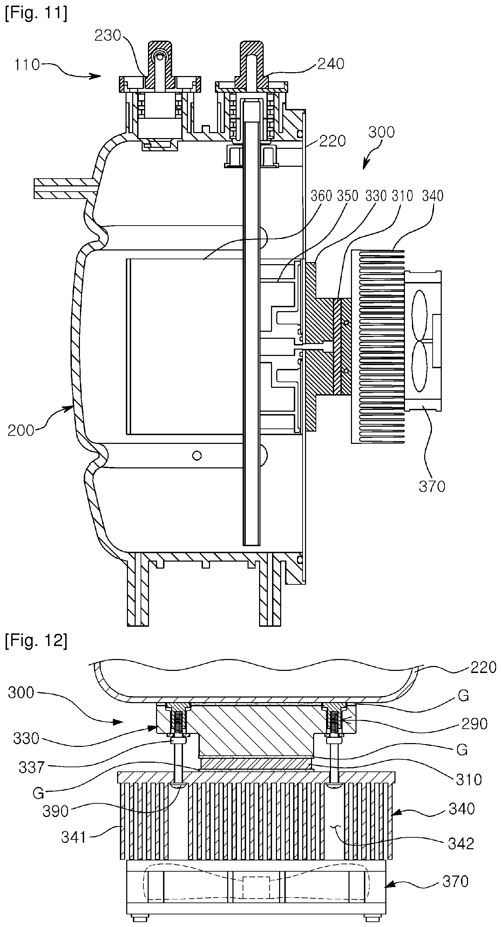

For reference, FIGS. 1 through 7 illustrate the cold water tank 110 according to an embodiment of the present invention, FIG. 8 illustrates the cold water tank 110 without a thermally conductive member 360 within a tank main body 200 unlike the cold water tank 110 illustrated in FIG. 7, and FIGS. 9 through 11 illustrate the cold water tank 110 denoted by reference numerals different from those of the cold water tank illustrated in FIGS. 1 through 3 of Korean Patent Application No. 2010-0137642 as a basis of a priority of the present application. FIGS. 12 to 15 illustrate embodiments showing a state in which only a cooling unit 300 is installed at an outer side of the tank main body 200 in a similar manner to that of the embodiment illustrated in FIG. 8, and FIGS. 16 through 19 are views for explaining a detailed configuration of a check valve 500 used for discharging air.

Hereinafter, common or equivalent components in respective embodiments are denoted by the same reference numerals and the configuration of the same reference numerals will be construed to have the same or similar function unless otherwise specified.

As shown in FIGS. 1 through 11, the cold water tank 110 according to an embodiment of the present invention includes a tank main body 200 and the cooling unit 300 having a thermoelectric module, and may further include an introduced water stabilization unit 400 and/or a check valve 500 used for discharging air (or an air discharge check valve) 500.

First, the tank main body 200 has a space for accommodating water therein, and includes a water inlet unit 230 through which water is introduced into the tank main body 200 and a water outlet unit 240 through which water accommodated in the tank main body 200 is discharged.

The shape or structure of the tank main body 200 is not particularly limited, and in order to facilitate installation of the introduced water stabilization unit 400, in order to enhance thermal conductivity and insulation characteristics, and/or in order to facilitate installation of the cooling unit 300 as explained hereinafter, the tank main body 200 may be divided into two or more body parts and then combined (or joined or assembled) to be formed.

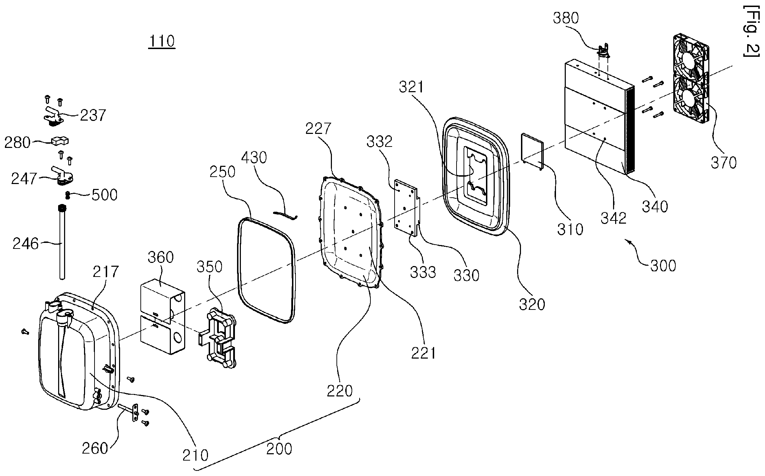

With reference to FIGS. 2, 6 through 8, 9, and 11, a first body 210 and a second body 220 may be combined to form an internal space of the tank main body 200. Meanwhile, in FIG. 2, it is illustrated that the first body 210 and the second body 220 are divided in a forward/backward direction and then combined. The first body 210 is made of a synthetic resin, so the tank main body 200 may be easily fabricated, and thus, fabrication costs can be reduced. Namely, of the tank main body 200, a portion having a complicated shape is made of a synthetic resin material to configure the first body 210, and the shape of the second body portion is simply configured, thus allowing the tank main body 200 easily fabricated to have having various shapes.

Here, when the first body 210 and the second body 220 are combined, preferably, a sealing member 250 is installed to prevent water leakage from the combined portion, and here, the sealing member 250 is mounted on a sealing member mounting opening 215 of the first body 210. Also, the first body 210 and the second body 220 may be combined by fastening fastening members such as screws or the like to a plurality of fastening portions 217 and 227. An appropriate number of fastening portions 217 and 227 may be may be formed at appropriate positions in consideration of an internal pressure of the tank main body 200 or the shape of the tank main body 200.

Meanwhile, as shown in FIGS. 7 and 8, the second body 220 has a rounded shape having a central portion higher than that of the circumference thereof. Namely, in the case of the direct type cold water tank 110, the internal pressure thereof may be increased, so, preferably, the cold water tank 110 has a rounded shape to appropriately cope with the pressure. Here, a cold sink 330 or a thermally conductive member 360 may be installed in the central portion of the second main body 220 as explained hereinafter, so, preferably, the second body 220 is formed to have a flat central portion in which the cold sink 330 or the thermally conductive member 360 are installed and curved circumference.

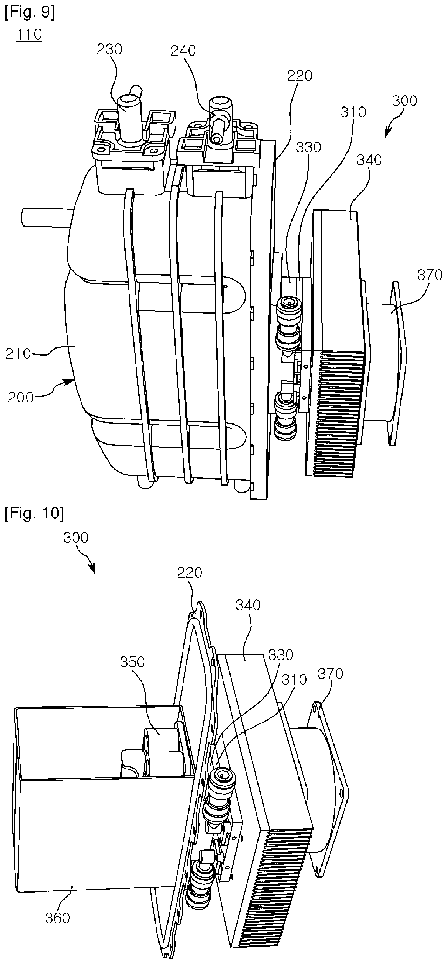

The shape of the second body 220 is limited to the foregoing rounded shape. Non-claimed examples of a plate-like shape are shown in FIGS. 9 through 11.

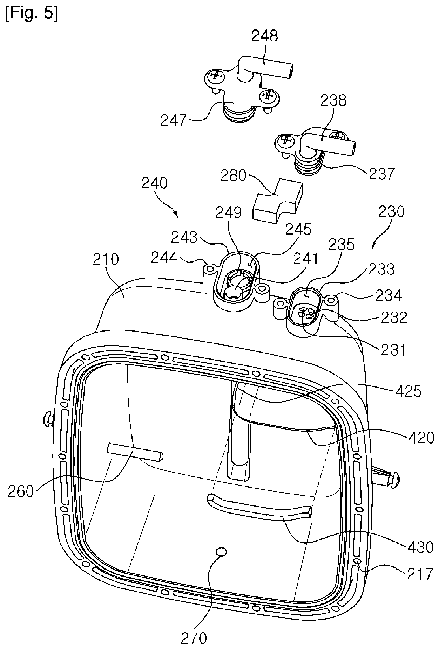

With reference to FIG. 5, the water inlet unit 230 of the tank main body 200 includes a water inlet 231 formed at an upper portion of the first body 210. Raw water from a hydrant, mineral water from a mineral water container, or purified water purified from a filter unit (not shown) may be introduced through the water inlet unit 230.

Here, the water inlet 231 is formed as a plurality of openings 232 to stabilize water introduced from a water inlet pipe 238 to allow the stabilized water to be applied to the tank main body 200.

Also, a buffer space 235 may be formed in the water inlet unit 230. Before introduced water is introduced into the tank main body 200, the buffer space 235 allows water supplied from the water inlet pipe 238 to be mixed with water accommodated in the buffer space 235 so as to be stabilized, and then, supplied to the tank main body 200. In order to form the buffer space 235, the water inlet unit 230 may include a protrusion 233 protruded from an upper face of the tank main body 200. Also, in order to prevent water introduced through the water inlet pipe 238 from being directly supplied to the water inlet 231 and effectively stabilize introduced water, preferably, the buffer space 235 communicates with the water inlet pipe 238 at a position which deviates from a directly overhead position of the water inlet 231.

Meanwhile, an upper side of the buffer space 235 is closed by a cover plate 237, and here, a sealing member such as an O-ring, or the like, may be installed between the protrusion 233 and the cover plate 237 in order to prevent generation of a water leakage. The cover plate 237 may be coupled to the tank main body 200 by a fastening unit 234.

The water outlet unit 240 of the tank main body 200 includes a water outlet 241 formed at an upper portion of the first body 210 of the tank main body 200. The water outlet unit 240 may have a buffer space 245 similar to that of the water inlet unit 230. A lateral side of the buffer space 245 may be formed by a protrusion 243, and an upper side of the buffer space 245 may be closed by a cover plate 247. Also, the cover plate 247 may be coupled to the tank main body 200 by a fastening unit 244 with a sealing member, such as an O-ring, or the like, interposed therebetween.

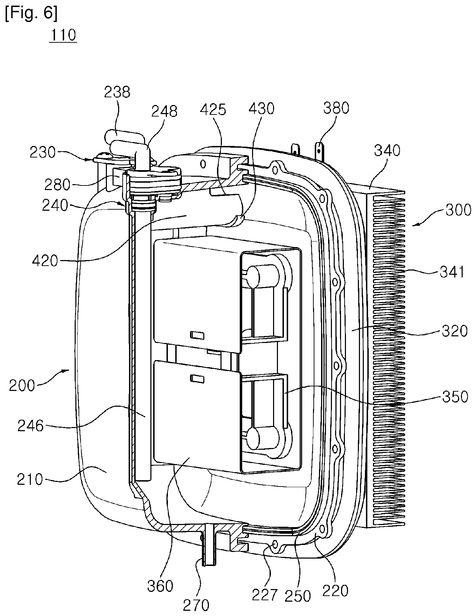

With reference to FIGS. 2 and 6, the water outlet unit 240 may have a water outlet guide pipe 246 downwardly extending in the tank main body to allow water to flow out from a lower portion of the tank main body 200. Water output through the water outlet guide plate 246 may be supplied to a user through the water outlet 241, the buffer space 245, and the water outlet pipe 248. Namely, the outlet unit 240 may be connected to a water outlet member (not shown), e.g., a cock, a faucet, or the like, provided in the water treatment apparatus such as a water purifier, or the like, and accordingly, cold water cooled by the cooling unit 300 as explained hereinafter can be provided to the user through the water outlet member.

Also, the air discharge check valve 500 may be provided in the tank main body 200 in order to discharge air accommodated within the tank main body 200 to the outside when water is introduced into the tank main body 200. Here, the air discharge check valve 500 may be installed in a check valve mounting portion (249 in FIGS. 5 and 7) formed in the water outlet unit 240, but the installation position of the air discharge check value 500 is not limited thereto. In particular, when the cold water tank 110 according to an embodiment of the present invention is used as a direct water type tank, the air discharge check valve discharges air when water is introduced into the tank main body 200, thereby preventing occurrence of a phenomenon in which water is not smoothly introduced by an internal pressure of the tank main body 200. The configuration of the air discharge check valve 500 will be described later.

Meanwhile, the water inlet pipe 238 and the water outlet pipe 248 may be integrally formed with the cover plates 237 and 247, respectively, but the present invention is not limited thereto so long as water flows in or out therethrough, and it is defined that configuration of a nipple or a separate hose is within the scope of the water inlet pipe 238 and the water outlet pipe 248.

A temperature sensor 260 may be mounted in the tank main body 200 in order to measure temperature of water accommodated within the tank main body 200, and a drain unit 270 may be provided at a lower portion of the tank main body 200 in order to drain water accommodated within the tank main body 200 to the outside.

Meanwhile, in the cold water tank 110 according to an embodiment of the present invention, since water having a low temperature is placed at the lower portion of the cold water tank 110, so, preferably, water flows out from the lower portion of the tank main body 200 through the water outlet guide pipe 246. Also, in order to prevent introduced water to be rapidly mixed with water having a low temperature placed at a lower portion of the cold water tank 110, namely, in order to maintain the output water at a low temperature, preferably, water introduced into the water inlet unit 230 is supplied to an upper portion of the tank main body 200.

Meanwhile, a water outlet insulation member 280 may be installed between the water inlet unit 230 and the water outlet unit 240. The water outlet insulation member 280 serves to prevent heat transmission between the water inlet unit 230 and the water outlet unit 240 to maintain the temperature of water being output.

The cooling unit 300 is configured as an electronic cooling device including a thermoelectric module in order to cool water accommodated within the tank main body 200. Here, the cooling unit 300, in a state of being coupled to the second body 220 of the tank main body 200, may be coupled to the first body 210, and the combination of the cooling unit 300 and the second body 220 may serve as a single cooling module. Namely, the cooling module formed by coupling the cooling unit 300 to the second body 220 made of a material having high thermal conductivity is airtightly coupled to cover one opened side of the first body 210, thus forming the cold water tank 110.

In this manner, when the cooling unit 300 is configured as an electronic cooling device including a thermoelectric module 310, a refrigerating system requiring devices such as an evaporator, a compressor, and the like, is not required, so water stored in the tank main body 200 can be cooled by a simple configuration.

With reference to FIGS. 2 and 6 through 15, the cooling unit 300 using the thermoelectric module (thermoelectric element) 310 may include the thermoelectric module (thermoelectric element) 310, the cold sink (cold block) 330, the heat sink 340, and a fan 370, and such a configuration of the electronic cooling device is known to have various shapes and structures, and the various known electronic cooling devices may be applicable to the cooling unit 300 of the present invention.

In the cooling unit 300, starting from an outer surface of the tank main body 200, the cold sink 330 transferring cold air from the thermoelectric module 310 to the tank main body 200, the thermoelectric module 310 generates heat and absorbs heat according to power application, the heat sink 340 including a heat dissipation member 341, and the fan 370 cooling the heat sink 340 are sequentially installed, and a temperature regulation switch 380 sensing the temperature of the heat sink 340 an determining whether to drive the fan 370 may be installed at one side of the heat sink 340.

In detail, as shown in various embodiments in FIGS. 2 and 6 through 15, one side of the cold sink 330 may be connected to the other side of the second body 220, and one side of the thermoelectric module 310 may be in contact with the other side of the cold sink 330.

Also, as illustrated in various embodiments in FIGS. 2 and 6 through 15, one side of the heat sink 340 is in contact with the other side of the thermoelectric module 310. Accordingly, when the thermoelectric module 310 operates, heat transferred from water stored in the tank main body 200 to the thermoelectric module 310 can be dissipated to the outside through the heat sink 340.

Also, as shown in FIGS. 2, 6, 7, 10, and 11, one side of the cold sink 330 may be connected to the second body 220 by a connection member 350 made of a synthetic resin material positioned within the tank main body 200. When the connection member 350 is made of a synthetic resin material, the connection member 350 does not corrode and can be easily fabricated to have various shapes.

However, as shown in FIGS. 8, and 12 through 15, the cold sink 330 may be attached to the second body 220 through a fastening member or through bonding, without using the connection member 250.

Also, in order to prevent the cold sink 330 from heat-exchanging with the outside, an insulating member 320 covering the cold sink 330 may be installed, and as shown in FIG. 2, an assembly opening 321 may be formed at the center of the insulating member 320 to allow the cold sink 330 to be installed therein. A fastening hole 332 of the cold sink 330 is provided to be coupled with the second body 220 of the tank main body 200. A fastening hole 333 of the cold sink 330 may be coupled to a fastening hole 342 of the heat sink 340 through a fastening member to couple the cold sink 330, the thermoelectric module 310, and the heat sink 340.

Meanwhile, as shown in FIGS. 2, 7, and 8, the cooling unit 300 may further include the thermally conductive member 360 installed within the tank main body 200 and the connection member 350 for attaching the thermally conductive member 360 to the second body 220.

The thermally conductive member 360 may be made of a metallic material having high thermal conductivity in order to provide cold air (cold heat) from the cold sink 330 in contact with the thermoelectric module 310 to water accommodated in the tank main body 200. Here, the thermally conductive member 360 may be made of stainless steel which is resistant to corrosion and does not contaminate water, but the present invention is not limited thereto.

Meanwhile, as in the embodiment illustrated in FIG. 2, the thermally conductive member 360 as a single member may have a ' 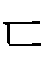 '-like shape, or two thermally conductive members 360 may be connected to the second body 220 by the connection member 350 such that the two thermally conductive members 360 face each other. However, the number or position of the thermally conductive member 360 are not particularly limited so long as heat can be easily transferred from water stored in the tank main body 200 to the second body 220 and the cold sink 330.

Also, preferably, the connection member 350 connects the thermally conductive member 360 to the cold sink 330 outside the tank main body 200. Here, in order to connect the thermally conductive member 360 to the cold sink 330 with the tank main body 200 interposed therebetween, a fastening member such as a screw or a bolt is required to be used from the cold sink 330 to the connection member 350 through the tank main body 200. When the fastening member is exposed to water accommodated within the tank main body 200, it may be corroded. Thus, preferably, a portion of the connection member 350 to which the fastening member is coupled is formed as a recess, not allowing passing through, such that the fastening member cannot be exposed from the connection member 350.

Meanwhile, preferably, the second body 220 on which the cooling unit 300 is installed is made of a metallic material to facilitate heat-exchange between water stored in the tank main body 200 and the thermoelectric module 310. For example, metal constituting the second body 220 may be stainless steel such as SUS, or the like, so that the surface of the second body 220 in contact with water cannot be corroded and does not contaminate water stored in the tank main body 200. However, the metal constituting the second body 220 may not be limited thereto and any metals may be used to constitute the second body 220 so long as it facilitates heat transmission between water stored in the tank main body 200 and the thermoelectric module 310 and is not corroded by water stored in the tank main body 200 so as not to contaminate water stored in the tank main body 200.

The second member 220 has a cladding structure in which heterogeneous metals are bonded. The interior (inner face of the tank main body) is made of stainless steel resistant to corrosion and the exterior (outer face of the tank main body) is made of aluminum or copper having excellent thermal conductivity. Since the second body 220 has a cladding structure, it has excellent thermal conductivity and does not have a possibility of corrosion.

According to the invention, the first body 210 is made of a synthetic resin material to effectively prevent heat-exchange with the outside through the first body 210, thus maximizing an insulating effect. In particular, since the first body 210 is formed to be larger than the second body 220, the effect of heat transmission through the second body 220 can be increased and the insulating effect through the first body 210 can be enhanced.

In addition, as the first body 210 is made of a synthetic resin, the first body 210 having a complicated shape can be easily fabricated, so various elements such as the introduced water stabilization unit 400 (to be described), or the like, can be easily formed.

In this manner, in the cold water tank 110 according to an embodiment of the present invention, since the first body 210 of the tank main body 200 is made of a synthetic resin, the tank main body 200 can be easily fabricated and the fabrication cost can be reduced, and since water stored in the tank main body 200 is cooled by the thermoelectric module 310, the cold water tank 110 can be cooled by a simple configuration. Also, since the second body 220 is made of a metallic material and the thermally conductive member 360 is installed within the tank main body 200, cooling efficiency of the cold water tank 110 can be enhanced.

Meanwhile, as shown in FIGS. 12 through 15, in the cold water tank 110 according to an embodiment of the present invention, the cooling unit 300 may be coupled to the outside of the second body 210 of the tank main body 200 by using a plurality of fastening members 290.

Namely, in the case of the embodiment illustrated in FIGS. 1 through 7 and 9 through 11, the cold sink 330, to which one side of the thermoelectric module 310 is connected to be in contact, and the second body 220 are connected by the connection member 350 positioned within the tank main body 200. In this case, through holes to be fastened to the connection member 350 should be formed on the second body 220, and thus, the cold water tank is required to be perfectly sealed.

Thus, in order to overcome the difficulty in ensuring airtightness, in the case of the embodiment illustrated in FIGS. 12 through 15, a plurality of fastening members 290 may be installed on an outer surface of the second body 220 to couple the cooling unit 300 to the second body 220 by using the fastening members 290.

The fastening members 290 may be attached to the second body 220 of the tank main body 200 through spot welding, brazing, or laser welding.

With reference to FIGS. 12 through 15, the fastening members 290 include a coupling hole, respectively, and a plurality of fastening holes 333 may be formed on the cold sink 300. The plurality of fastening holes 333 are formed at positions corresponding to the plurality of fastening members 290 as mentioned above, respectively.

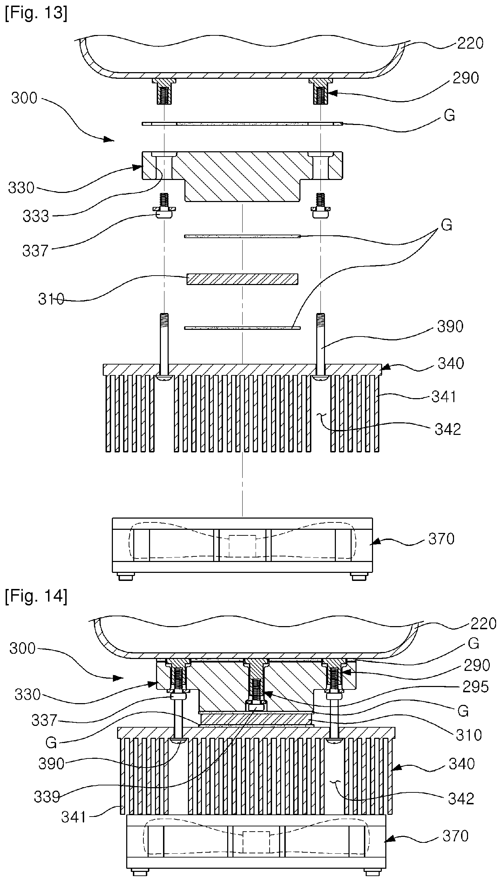

Thus, as in the embodiment illustrated in FIGS. 12 and 14, the plurality of fastening members 290 may be inserted into one side of each of the plurality of fastening holes 333. Also, a plurality of coupling members 337 are inserted into the other side of each of the plurality of fastening holes 333 so as to be coupled to the plurality of fastening members 290.

To this end, female thread may be formed in the coupling holes of the fastening members 290 and the coupling members 337 may be formed as bolts as in the embodiment illustrated in FIGS. 12 through 15. Accordingly, the coupling members 337, bolts, can be screw-connected into the coupling holes of the fastening members 290. However, the configuration of coupling the coupling members 337 to the fastening members 290 is not limited to the illustrated embodiment and any configuration, such as rivet coupling, or the like, may be applicable so long as it allows the coupling member 337 to be coupled to the fastening member 290.

Meanwhile, as shown in FIGS. 12 through 15, a thermally conductive grease G may be positioned between the cold water tank 110 and the cold sink 330. Accordingly, as mentioned above, heat can be smoothly transferred from water accommodated in the tank main body 200 to the cold sink 330 according to driving of the thermoelectric module 310. The thermally conductive grease G is not particularly limited and any known grease may be used so long as it can smoothly transfer heat from water accommodated in the tank main body 200 to the cold sink 330.

Also, as in the embodiment illustrated in FIG. 14, at least one fastening member 295 may be attached to a central portion of the second body 220 of the tank main body 200. When at least one fastening member 295 is attached to the central portion of the second body 220 of the tank main body 200, formation of a gap between the second body 220 and the cold sink 330 can be prevented. Accordingly, one side of the cold sink 330 can be stably in contact with the cold water tank 110. Thus, heat can be smoothly transferred from water accommodated in the cold water tank 110 to the cold sink 330 according to driving of the thermoelectric module 310.

Also, as in the embodiment illustrated in FIGS. 12 through 15, the thermally conductive grease G may be positioned between the cold sink 330 and the thermoelectric module 310. Accordingly, as mentioned above, heat transferred from water accommodated in the tank main body 200 to the cold sink 330 according to the driving of the thermoelectric module 310 can be smoothly transferred to the thermoelectric module 310. The thermally conductive grease G is not particularly limited as mentioned above.

Meanwhile, as illustrated in FIGS. 12 through 15, a plurality of coupling member insertion holes 342 may be formed on the heat sink 340 in contact with the other side of the thermoelectric module 310. Coupling members 390, different from the coupling members 337 coupled to the plurality of fastening members 290, respectively, may be inserted into the coupling member insertion holes 342, respectively.

Also, the plurality of fastening holes 333 formed on the cold sink 330 may correspond to the plurality of coupling member insertion holes 342 of the heat sink 340 as mentioned above, respectively. Accordingly, as shown in FIGS. 12 and 14, the plurality of coupling members 390 inserted into the plurality of coupling member insertion holes 342 of the heat sink 340 may be coupled to the plurality of fastening holes 333 of the cold sink 330, respectively. Thus, as in the embodiment illustrated in FIGS. 12 and 14, the cold sink 330 is in contact with one side of the thermoelectric module 310 and the heat sink 340 may be in contact with the other side of the thermoelectric module 310.

In order to couple the coupling members 390, female threads may be formed in the coupling members 337. As in the embodiment illustrated in FIGS. 12 through 15, the coupling members 390 may be configured as bolts which are screw-connected to the coupling members 337 or a known coupling unit may be employed.

Also, as in the embodiment illustrated in FIGS. 12 through 15, the thermally conductive grease G may be positioned between the thermoelectric module 310 and the heat sink 340. Accordingly, as mentioned above, heat transferred to the cold sink 330 and the thermoelectric module 310 from water accommodated in the tank main body 200 according to the driving of the thermoelectric module 310 can be smoothly transferred to the heat sink 340.

The introduced water stabilization unit 400 provided in the cold water tank 110 according to an embodiment of the present invention will be described as follows.

The introduced water stabilization unit 400 provided in the tank main body 200 serves to prevent introduced water introduced from the water inlet unit 230 from being rapidly mixed with stored water accommodated within the tank main body 200. Namely, the introduced water stabilization unit 400 may allow introduced water to be stabilized to the maximum and then mixed with stored water, thus preventing introduced water from being rapidly mixed with stored water.

As shown in FIGS. 2 and 3 through 8, the introduced water stabilization unit 400 may include a partition member 420 partitioning an introduced water space 201 to which introduced water is introduced and a stored water space 202 in which stored water is accommodated, and having a communication opening 425 allowing the introduced water space 201 and the stored water space 202 to communicate therethrough.

Here, when the tank main body 200 is formed by combining the first body 210 and the second body 220, the partition member 420 may be formed in the first body 210. Thus, the partition member 420 forms the introduced water space 201 and the stored water space 202 as the first body 210 and the second body 220 are combined. In this case, in order to completely separate the introduced water space 201 and the stored water space 202 through the partition member 420, a sealing member 430 may be provided between the partition member 420 and the second body 220 to block a flow of water in portions other than the communication opening 425.

Also, the introduced water stabilization unit 400 may further include a mixing retarding plate 410 installed in the introduced water space 201 to allow introduced water introduced through the water inlet unit 230 to collide therewith.

Such a mixing retarding plate 410 serves to prevent water, introduced into the introduced water space 201 formed by the partition member 420, from immediately moving to the stored water space 202. In particular, when introduced water is introduced, the mixing retarding plate 410 allows introduced water to first collide therewith, to thus reduce a flow velocity of the introduced water.

Here, the mixing retarding plate 410 has a V-shape with a central portion, positioned below the water inlet 231 provided in the water inlet unit 230, downwardly bent to thus serve to temporarily house introduced water dropped mixing retarding plate 410.

As mentioned above, in the introduced water space 201 and the stored water space 202, a flow of water is generated through the communication opening 425 of the partition member 420. Here, in order to prevent water, introduced through the water inlet 231, from immediately flowing out through the communication opening 425, as shown in FIGS. 5 and 6, preferably, the water inlet 231 provided in the water inlet unit 230 and the communication opening 425 are positioned to be opposite based on a thicknesswise direction of the tank main body 200.

Also, in order to prevent water introduced into the introduced water space 201 from being immediately discharged through the communication opening 425, preferably, the communication opening 425 is installed at an upper edge of the introduced water space 201, namely, at an upper portion of the partition member 420. Thus, since the communication opening 425 is installed at the upper edge of the partition member 420, introduced water rises up from the lower side to pass through the communication opening 425 so as to be supplied to the stored water space 202.

Also, as mentioned above, when the buffer space 235 is formed in the water inlet unit 230 or when the water inlet 231 is configured as a plurality of openings 232, stabilized introduced water is supplied to the introduced water stabilization unit 400, further increasing the introduced water stabilization effect.

Meanwhile, in the above description, the partition member 420 partitions the introduced water space 201 and the stored water space 202, but the partition member 420 may be configured such that one side thereof (e.g., a portion adjacent to the second body 220), other than the communication opening 425, is open. In such a case, the mixing retarding plate 410 primarily retards mixing of introduced water introduced from the water inlet unit 230 with the stored water already accommodated in the tank main body 200, and the partition member 420 secondarily retards mixing of water, which has passed through the mixing retarding plate 410, with the stored water already accommodated in the tank main body 200.

Meanwhile, as shown in FIG. 6, preferably, the communication opening 425 of the partition member 420 is positioned in an upper part of a portion to which the thermoelectric module 310 is coupled to allow introduced water to flow to the portion to which the thermoelectric module 310 is coupled through the communication opening 425 of the partition member 420. Through this configuration, although the introduced water introduced to the stored water space 202 moves downward, it can be sufficiently cooled by the cooling unit 300, whereby the temperature of output water can be lowered.

In particular, as shown in FIGS. 6 and 7, when the thermally conductive member 360 is installed within the tank main body 200, preferably, the communication opening 425 of the partition member 420 is positioned in an upper part of the thermally conductive member 360 to allow introduced water to be brought into contact with the thermally conductive member 360 through the communication opening 425.

Hereinafter, the air discharge check valve 500 provided in the cold water tank 200 according to an embodiment of the present invention will be described with reference to FIGS. 5, 7, and 16 through 19.

The air discharge check valve 500 includes a housing 510, an opening and closing member 530, an elastic member 550, and a movement limiting member 570.

As shown in FIGS. 5 and 7, the air discharge check valve 500 may be mounted in a check valve mounting hole 249 provided at an upper portion of the tank main body 200. Accordingly, the housing 510 may be installed to pass through a portion of the upper portion of the tank main body 200 and has a hollow portion 511 therein. A stop protrusion 515 is formed at an upper portion of the housing 510, by which the air discharge check valve 500 is placed over the check valve mounting hole 249 of the tank main body 200.

Meanwhile, the opening and closing member 530 may be positioned in the hollow portion 511 of the housing 510, move up and down along the hollow portion 511 of the housing 510, and have an air discharge passage 531 to allow air to move therealong.

Namely, for example, as illustrated, the opening and closing member 530 may be formed as a shaft to be inserted into the hollow portion 511 of the housing 510, and guided by the hollow portion 511 therein so as to be mounted to move up and down. Here, when the opening and closing member 530 descends, the air discharge check valve 500 may be opened, and when the opening and closing member 530 ascends, the opening and closing member 530 may be closed.

The opening and closing member 530 may include the air discharge passage 531 allowing air to move therealong so that air can be discharged between the opening and closing member 530 and the interior of the housing 510.

Meanwhile, the elastic member 550 may be accommodated in the hollow portion 511 of the housing 510 in order to elastically press the opening and closing member 530. In detail, the elastic member 550 may be configured as, for example, an elastic spring, and inserted into the opening and closing member 530 and supported by the opening and closing member 530 within the housing 510 to elastically press the opening and closing member 530 downwardly.

Accordingly, the opening and closing member 530 is usually maintained in a lowered state by the elastic force of the elastic member 550, and as the opening and closing member 530 is lowered, the check valve 500 is opened to allow air to be discharged to the air discharge passage 531.

Meanwhile, the movement limiting member 570 is inserted into the opening and closing member 530 and mounted on an upper portion of the housing 510 to limit the movement of the opening and closing member 530. Namely, the opening and closing member 530 is provided to move up and down within the hollow portion 511 of the housing 510, and here, the movement limiting member 570 may be provided to restrict the opening and closing member 530 from moving to a lower side of the housing 510 by gravitation.

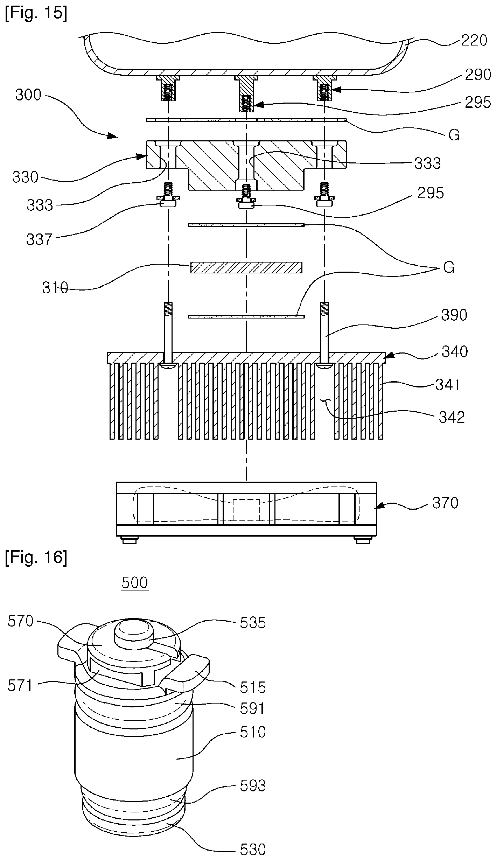

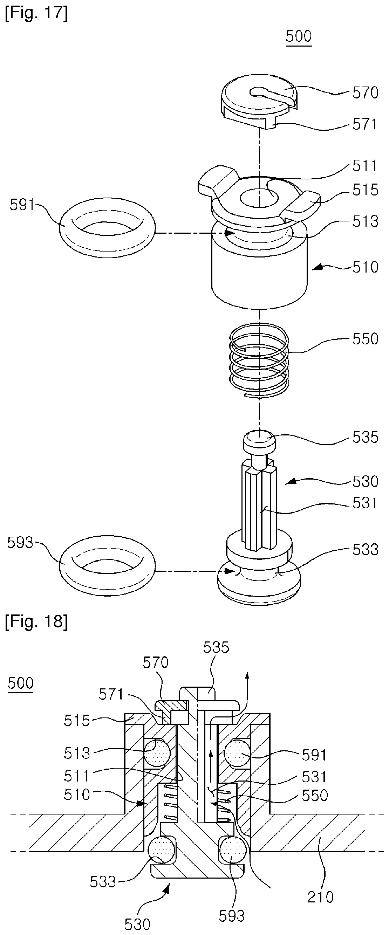

Here, for example, as shown in FIGS. 16 and 17, the movement limiting member 570 is inserted into an upper portion of the opening and closing member 530 and disposed between a support protrusion 535 and an upper edge of the housing 510 to limit movement of the opening and closing member 530 to a lower side. Here, the shape of the movement limiting member 570 is not limited to the illustrated example, and may be variably modified so long as it can prevent the opening and closing member 530 from being dropped downwardly.

The air discharge check valve 500 configured as described above may be installed in the tank main body 200 of the cold water tank 110, or the like, to discharge air within the tank main body 200 to the outside to thus release the air pressure within the tank main body 200 to facilitate water introduced into the tank 110. Also, when a certain amount of water is introduced into the tank main body 200, the opening and closing member 530 rises up due to the pressure within the tank main body 200 to shut the air discharge check valve 500, thus sealing the tank main body 200.

Meanwhile, the opening and closing member 530 has a cross-shaped section and has the air discharge passage 531.

Namely, as shown in FIGS. 16 through 19, the opening and closing member 530 is provided as a shaft having a cross-shaped section and the air discharge passage 531 is formed between the protruded portions. When the opening and closing member 530 is lowered, air introduced into the housing 510 can move up through the air discharge passage 531.

Here, however, the sectional shape of the opening and closing member 530 is not limited to the illustrated shape, and the opening and closing member 530 may be variably modified so long as it can allow air to move between the opening and closing member 530 and an inner circumferential surface of the housing 510.

Meanwhile, the movement limiting member 570 includes a rib 571 to form an opening space at a lower portion thereof to allow air to be discharged between the support protrusion 535 provided at the upper edge of the opening and closing member 530 and the upper portion of the housing 510.

For example, with reference to the embodiment illustrated in FIGS. 16 and 17, two ribs 571 are formed on a lower portion of the movement limiting member 570, having an opening space therebetween. The opening space is formed to communicate with the hollow portion 511 of the housing 510 and the air discharge passage 531 to allow air, introduced into the housing 510, to be discharged to the outside through the opening space formed between the ribs 571 after passing through the air discharge passage 531.

Here, the ribs 571 are not limited to the illustrated shape and may be variably modified so long as it can form an opening space between the movement limiting member 570 and the housing 510 and discharge air.

Meanwhile, the housing 510 may include a first insertion recess 513 into which a first sealing member 591 sealing a gap between the housing 510 and a device in which the housing 510 is mounted is inserted.

Namely, as in the embodiment illustrated in FIGS. 5, 7, and 16 through 19, the housing 510 may be inserted through the device, e.g., the tank main body 200, or the like, in which the check valve 500 is mounted, and in this case, the insertion recess 513 is formed on the housing 510 and the first sealing member 591 is inserted into the first insertion recess 513, thereby sealing a gap between the housing 510 and the tank main body 200. Accordingly, water or air can be prevented from flowing through a gap between the housing 510 and the tank main body 200, or the like.

Also, the opening and closing member 530 may include a second insertion recess 533 into which a second sealing member 593 for sealing a gap between the housing 510 and the opening and closing member 530 is inserted.

Namely, with reference to the embodiment illustrated in FIGS. 16 through 19, the second insertion recess 533 is formed at a lower portion of the opening and closing member 530 to allow the second sealing member 593 to be inserted therein. Accordingly, when the opening and closing member 530 ascends, a gap between the opening and closing member 530 and the housing 510 can be sealed by the second sealing member 593. Thus, air can be prevented from being leaked when the check valve 500 is shut.

Here, the first sealing member 591 and the second sealing member 593 may have any shape or may be made of any material so long as they can hermetically seal a gap between the housing 510 and the tank main body 200 or between the opening and closing member 530 and the housing 510. For example, the first sealing member 591 and the second sealing member 593 may be configured as a rubber packing or a rubber O-ring.

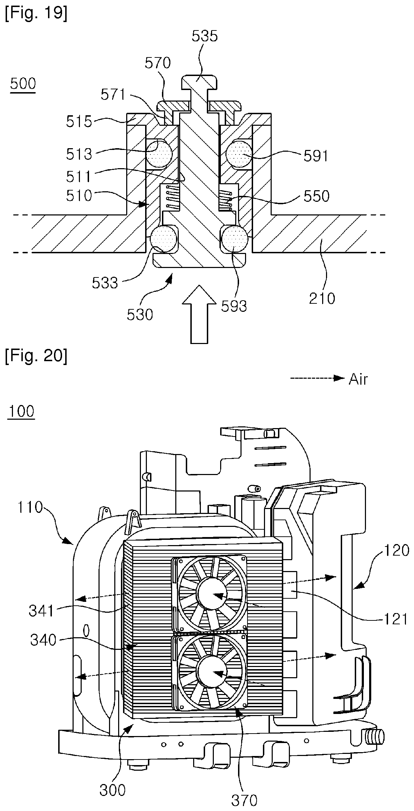

Hereinafter, the operation of the air discharge check valve 500 and the cold water tank 110 will be described with reference to FIGS. 18 and 19.

First, the check valve 500 is mounted in the check valve mounting hole 249. Here, the housing 510 is mounted to pass through a portion of the upper portion of the check valve mounting hole 249, and the opening and closing member 530 is provided to move up and down in the hollow portion 511 of the housing 510.

FIG. 18 shows an opened state of the air discharge check valve 500. With reference to FIG. 18, the opening and closing member 530 is lowered by the elastic member 550, and air within the tank main body 200 may be introduced between the opening and closing member 530 and the housing 510. Here, the introduced air moves upward through the air discharge passage 531 of the opening and closing member 530 and then is discharged to the outside through the space between the ribs 571 of the movement limiting member 570 communicating with the air discharge passage 531.

Accordingly, the pressure of air within the tank main body 200 is released and water can be smoothly introduced from the water inlet unit 230.

Meanwhile, FIG. 19 shows a closed state of the air discharge check valve 500. With reference to FIG. 19, when water more than a certain amount is introduced into the tank main body 200 to increase the internal pressure of the tank main body 200, the opening and closing member 530 is lifted by the internal pressure, closing the opening and closing member 530 and the housing 510. Accordingly, air within the tank main body 200 cannot be discharged to the outside and the tank main body 200 is airtight.

In this case, air within the tank main body 200 cannot be discharged to the outside by virtue of the second sealing member 593 provided in the second insertion recess 533, so a gap between the opening and closing member 530 and the housing 510 can be sealed.

In this manner, when air is introduced into the tank main body 200, air is discharged through the air discharge check valve 500 to release air pressure in the tank main body 200, thus allowing water to be smoothly introduced. Also, when the internal pressure of the tank main body 200 is increased according to water introduced, the air discharge check valve 500 is automatically shut, thereby obtaining the effect that water can smoothly flow in and out through a simple configuration.

Meanwhile, the water treatment apparatus 100 according to an embodiment of the present invention may include the foregoing cold water tank 110 and the water outlet member (not shown) such as a cock, or the like, provided to extract water accommodated in the cold water tank 110. The water treatment apparatus 100, such as a water purifier, or the like, may be configured to have a filter unit (not shown) at a front stage of the cold water tank 110 to allow water filtered by the filter unit to be stored in the cold water tank 110.

Also, the water treatment apparatus 100 according to an embodiment of the present invention may be configured to allow at least a portion of air which has cooled the thermoelectric module 310 included in the cooling unit 300 to flow to a power supply device 120 supplying power to the cooling unit 300, in order to cool the power supply device 120.

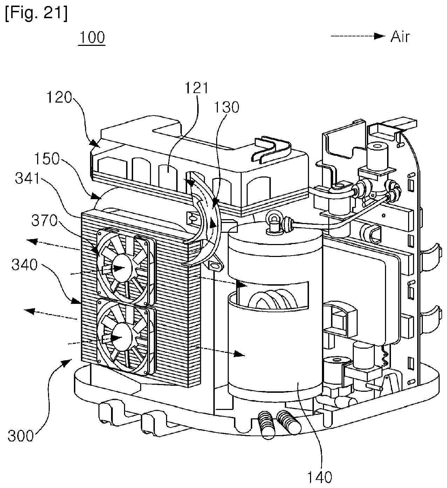

As shown in FIGS. 20 and 21, the power supply device 120 may be electrically connected to the cooling unit 300 including the thermoelectric module 310. Accordingly, power can be supplied to the thermoelectric module 310 and the fan 370 provided in the cooling unit 300 by the power supply device 120.

The power supply device 120 may be, for example, a switched-mode power supply (SMPS). However, the power supply device 120 is not limited thereto and any known power supply device may be used so long as it can supply power to the cooling unit 300 including the thermoelectric module 310.

Also, although not shown, the cold water tank 110 may be connected to a plurality of water purifying filters provided in the water treatment apparatus 100 to filter water. Accordingly, water filtered through the plurality of water purifying filters can be accommodated in the tank main body 200. Water accommodated in the cold water tank 110 can be cooled by the cooling unit 300 including the thermoelectric module 310.

Meanwhile, when power is supplied to the fan 370 by the power supply device 120, the fan 370 is driven. According to the driving of the fan 370, external air is introduced to the heat sink 340 as in the embodiment illustrated in FIGS. 20 and 21. Since air introduced into the heat sink 340 has a temperature lower than that of the heat sink 340 having an increase temperature due to the heat transmission as mentioned above, heat is transferred from the heat sink 340 to the air introduced to the heat sink 340. Air having the increased temperature according to the heat transmission from the heat sink 340 is discharged to the outside from the heat sink 340. Accordingly, the heat sink 340 is cooled and the thermoelectric module 310 connected to the heat sink 340 can be cooled.

To this end, as in the embodiment illustrated in FIGS. 20 and 21, a plurality of heat dissipation members 341 may be provided in the heat sink 340. Thus, heat transferred to the heat sink 340 is transferred to the plurality of heat dissipation members 341. And, as described above, when external air is introduced into the heat sink 340 according to driving of the fan 370, the introduced air, flowing among the plurality of heat dissipation members 341, receive heat from the plurality of heat dissipation members 341 and then flows out. Accordingly, the plurality of heat dissipation members 341 are cooled to cool the heat sink 340.

Meanwhile, as described above, the water treatment apparatus 100 according to an embodiment of the present invention may be configured to allow at least a certain amount of air cooling the thermoelectric module 310 to flow to the power supply device 120 to cool the power supply device 120. Namely, as described above, air introduced to the heat sink 340 and receiving heat from the heat sink 340, thus having an increased temperature, has a temperature lower than that of the power supply device 120. So, the air introduced to the heat sink 340 may be forced to flow to the power supply device 120 to allow heat from the power supply device 120 to be transferred to the air to thereby cool the power supply device 120.

Accordingly, the power supply device 120 can be cooled without using any additional cooling means such as a fan (not shown), besides the fan 370 included in the foregoing cooling unit 300. In this manner, since an additional cooling means is not required to cool the power supply device 120, the product of the water treatment device 100 such as a water purifier, or the like, can reduced in size. Also, since an additional cooling means for cooling the power supply device 120, besides the fan 370 included in the foregoing cooling unit 300, is not required, there is no necessity of supplying additional power, enhancing energy efficiency.

In detail, as in the embodiment illustrated in FIG. 20, the power supply device 120 may be positioned at an air outflow side of the heat sink 340. Accordingly, air introduced into the heat sink 340 and cooled the heat sink 340 flows to the power supply device 120 to directly cool the power supply device 120 and then flows out.

As in the embodiment illustrated in FIG 20, air introduced into the heat sink 340 can flow out from both sides of the heat sink 340. In such a case, the power supply device 120 may be positioned at either side of the heat sink 340 as in the illustrated embodiment. Also, as in the embodiment illustrated in FIG. 20, a plurality of air inflow/ outflow holes 121 allowing air to flow in and out may be formed in the power supply device 120. In this case, in the power supply device 120, the air inflow/outflow holes 121 may be positioned to face either side of the heat sink 340.

As shown in FIG. 20, when the power supply device 120 is disposed at one side of the heat sink 340, since a relatively large amount of air which has cooled the heat sink 340 can flow to the power supply device 120, the power supply device 120 can be rapidly, evenly cooled overall.

Meanwhile, as in the embodiment illustrated in FIG. 21, when a different configuration, e.g., a hot water tank 140, is provided in the product such as the water treatment apparatus 100, or the like, in addition to the cold water tank 110 including the cooling unit 300, there may not be a sufficient space for positioning the power supply device 120 at the air outflow side of the heat sink 340 as shown in FIG. 20. In this case, the power supply device 120 may be positioned, for example, at an upper side of the cooling unit 300 as shown in FIG. 21, rather than being positioned at the air outflow side of the heat sink 340 as mentioned above.

In such a case, an air guide unit 130 may be provided between the heat sink 340 and the power supply device 120. Accordingly, at least a certain amount of air flowing out of the heat sink 340 may flow to the power supply device 120 through the air guide unit 130 to cool the power supply device 120. The air, which has cooled the power supply device 120, may flow out.

To this end, one side of the air guide unit 130 may be positioned at the air outflow side of the heat sink 340, and the other side thereof may be positioned at the power supply device 120.

As shown in FIG. 21, air introduced into the heat sink 340 may flow out from both sides of the heat sink 340, and in this case, one side of the air guide unit 130 may be positioned at one of the both sides of the heat sink 340. Also, when the plurality of air inflow/outflow holes 121 are formed to allow air to flow out to the power supply device 120 as in the illustrated embodiment, the other side of the air guide unit 130 may be positioned at one (or some) of the air inflow/outflow holes 121.

Meanwhile, as in the embodiment illustrated in FIG. 21, a sectional area of one side of the air guide unit 130 may be greater than that of the other side of the air guide unit 130. When the sectional area of one side of the air guide unit 130 may be greater than that of the other side of the air guide unit 130, the speed of air is faster when it flows out to the other side of the air guide unit 130 than the speed of air when it is introduced into one side of the air guide unit 130 according to Bernoulli's theorem, and accordingly, a convective heat transfer coefficient of air is increased. Thus, as in the illustrated embodiment, although a certain amount of air flowing out of the heat sink 340 is introduced into the air guide unit 130, the power supply device 120 can be smoothly cooled.

Meanwhile, as in the embodiment illustrated in FIG. 21, the foregoing air guide unit 130 may be a duct. As illustrated, the duct has one side opened and may form an air flow path with a device, e.g., the water treatment apparatus 100 in the illustrated embodiment, in which the power supply device 120 is installed. Namely, since the opened one side of the duct is in contact with the housing of the water treatment apparatus 100 so as to be closed, an air flow path can be formed to allow air to flow from one side of the duct to the other side thereof.

However, the air guide unit 130 is not limited to the duct as in the embodiment illustrated in FIG. 21, and any known unit such as a pipe, or the like, besides the duct, may be employed so long as it is provided between the heat sink 340 and the power supply device 120 to allow at least a certain amount of air flowing out from the heat sink 340 to flow to the power supply device 120 to cool the power supply device 120.

## Claims

1. A cold water tank comprising:
a tank main body (200) including a first body (210) and a second body (220) combined to form an internal space therein; and
a cooling unit (300) including a thermoelectric module (310) cooling water accommodated within the tank main body (200),
wherein the second body (220) has a cladding structure in which heterogeneous metals are joined, and the interior of the second body (220) is made of stainless steel and the exterior thereof is made of aluminum or copper, wherein the second body (220) has a rounded shape having a central portion higher than that of the circumference thereof, and the thermoelectric module (310) is connected to the second body (220) to cool the second body (220), and
**characterized in that**
the first body (210) and the second body (220) are divided in a forward-backward direction and then combined to form an internal space therein, and wherein
the first body (210) is made of a synthetic resin material and formed to be larger than the second body (220).

2. The cold water tank of claim 1, wherein the cooling unit (300) comprises:
a cold sink (330) having one side connected to the other side of the second body (220) and the other side in contact with one side of the thermoelectric module (310); and
a heat sink (340) having one side in contact with the other side of the thermoelectric module (310),
wherein a thermally conductive member (360)made of a metallic material is installed at one side of the second body (220) and accommodated in the internal space of the tank main body (200),
the thermally conductive member (360) is fixed to the second body (220) by a connection member (350) positioned at one side of the second body (220),
and the connection member (350) connects the thermally conductive member (360), the second body (220), and the cold sink (330).

3. The cold water tank of claim 1 or claim 2, wherein the cooling unit (300) is attached to the second body (220) by a plurality of fastening members attached to the outer side of the second body (220).

4. The cold water tank of claim 1, further comprising an introduced water stabilization unit (400) provided on the tank main body (200) to prevent introduced water introduced from a water inlet unit (230) formed on the first body (210) from being rapidly mixed with stored water accommodated within the tank main body (200),
wherein the introduced water stabilization unit (400) comprises:
a mixing retarding plate (410) primarily retarding mixing of the introduced water introduced from the water inlet unit (230) with the stored water already accommodated in the tank main body (200); and
a partition member (420) secondarily retarding mixing of water that passes through the mixing retarding plate with the stored water already accommodated in the tank main body (200) and having a communication opening (425) allowing the introduced water to be mixed with the stored water.

5. The cold water tank of claim 1, wherein the tank main body (200) comprises the water inlet unit (230) and the water outlet unit (240), and the water inlet unit (230) comprises a buffer space (235) temporarily storing water introduced from the outside before the water is introduced to the tank main body (200) through the water inlet (231).

6. The cold water tank of claim 5, wherein the buffer space (235) communicates with a water inlet pipe (238) at a position which deviates from a directly overhead position of the water inlet (231) provided in the water inlet unit (230).

7. A water treatment apparatus comprising:
the cold water tank (110) according to any one of claims 1 to 6;
a water outlet member extracting water accommodated in the cold water tank (110); and
a power supply device (120) electrically connected to a cooling unit (300) of the cold water tank (110),
wherein at least a certain amount of air that cools a thermoelectric module (310) provided in the cooling unit (300) of the cold water tank (110) flows to the power supply device (120) to cool the power supply device (120).

8. The water treatment apparatus of claim 7, wherein the cooling unit (300) provided in the cold water tank (110) comprises:
a heat sink (340) connected to the other side of the thermo electric module (310),
wherein the power supply device (120) is positioned at an air outflow side of the heat sink (340) so as to be directly cooled by air flowing out from the heat sink (340).

9. The water treatment apparatus of claim 8, wherein air introduced into the heat sink (340) flows out from both sides of the heat sink (340), and the power supply device (120) is positioned at either side of the heat sink (340).

10. The water treatment apparatus of claim 9, wherein a plurality of air inflow/outflow holes (121) allowing air to flow in and out therethrough are formed on the power supply device (120), and the air inflow/outflow holes (121) of the power supply device (120) are positioned to face either side of the heat sink (340).

11. The water treatment apparatus of claim 8, wherein an air guide unit (310) is provided between the heat sink (340) and the power supply device (120) to guide at least a certain amount of air flowing out from the heat sink (340) to flow to and cool the power supply device (120).

12. The water treatment apparatus of claim 11, wherein one side of the air guide unit (310) is positioned at the air outflow side of the heat sink (340) and the other side thereof is positioned at the power supply device (120).

13. The water treatment apparatus of claim 12, wherein air introduced into the heat sink (340) flows out from both sides of the heat sink (340), and one side of the air guide unit (310) is positioned at either side of the heat sink (340).

14. The water treatment apparatus of claim 13, wherein the other side of the air guide unit is positioned at the plurality of air inflow/outflow holes (121) formed on the power supply device (120).

## Patentansprüche

1. Kaltwasserbehälter, umfassend:
einen Behälterhauptkörper (200), umfassend einen ersten Körper (210) und einen zweiten Körper (220), die kombiniert sind, um darin einen Innenraum auszubilden; und
eine Kühleinheit (300) mit einem thermoelektrischen Modul (310) zum Kühlen von Wasser, das in dem Behälterhauptkörper (200) aufgenommen ist,
wobei der zweite Körper (220) eine Umhüllungsstruktur aufweist, in der heterogene Metalle verbunden sind, und das Innere des zweiten Körpers (220) aus Edelstahl hergestellt ist und das Äußere davon aus Aluminium oder Kupfer hergestellt ist,
wobei der zweite Körper (220) eine abgerundete Form mit einem mittigen Abschnitt aufweist, der höher als jener des Umfangs davon ist, und das thermoelektrische Modul (310) mit dem zweiten Körper (220) verbunden ist, um den zweiten Körper (220) zu kühlen,
und
**dadurch gekennzeichnet, dass**
der erste Körper (210) und der zweite Körper (220) in einer Vorwärts-RückwärtsRichtung geteilt und dann kombiniert sind, um einen Innenraum darin auszubilden, und wobei
der erste Körper (210) aus einem Kunstharzmaterial hergestellt und so ausgebildet ist, dass er größer als der zweite Körper (220) ist.

2. Kaltwasserbehälter nach Anspruch 1, wobei die Kühleinheit (300) Folgendes umfasst:
eine Kältesenke (330), deren eine Seite mit der anderen Seite des zweiten Körpers (220) verbunden und deren andere Seite mit einer Seite des thermoelektrischen Moduls (310) in Kontakt ist; und
eine Wärmesenke (340), deren eine Seite mit der anderen Seite des thermoelektrischen Moduls (310) in Kontakt ist,
wobei ein wärmeleitfähiges Element (360), das aus einem metallischen Material hergestellt ist, auf einer Seite des zweiten Körpers (220) installiert und in dem Innenraum des Behälterhauptkörpers (200) aufgenommen ist,
das wärmeleitfähige Element (360) an dem zweiten Körper (220) durch ein Verbindungselement (350) befestigt ist, das an einer Seite des zweiten Körpers (220) angeordnet ist,
und das Verbindungselement (350) das wärmeleitfähige Element (360), den zweiten Körper (220) und die Kältesenke (330) verbindet.

3. Kaltwasserbehälter nach Anspruch 1 oder Anspruch 2, wobei die Kühleinheit (300) an dem zweiten Körper (220) durch eine Mehrzahl von Befestigungselementen angebracht ist, die an der Außenseite des zweiten Körpers (220) angebracht sind.

4. Kaltwasserbehälter nach Anspruch 1, ferner umfassend eine Stabilisierungseinheit (400) für eingeleitetes Wasser, die an dem Behälterhauptkörper (200) vorgesehen ist, um zu verhindern, dass eingeleitetes Wasser, das von einer Wassereinlasseinheit (230), die an dem ersten Körper (210) ausgebildet ist, eingeleitet wird, rasch mit gespeichertem Wasser, das in dem Behälterhauptkörper (200) aufgenommen ist, gemischt wird,
wobei die Stabilisierungseinheit (400) für eingeleitetes Wasser Folgendes umfasst:
eine Mischverzögerungsplatte (410), die primär ein Mischen des eingeleiteten Wassers, das von der Wassereinlasseinheit (230) eingeleitet wird, mit dem gespeicherten Wasser, das bereits in dem Behälterhauptkörper (200) aufgenommen ist, verzögert; und
ein Trennelement (420), das sekundär ein Mischen von Wasser, das die Mischverzögerungsplatte durchströmt, mit dem gespeicherten Wasser, das bereits in dem Behälterhauptkörper (200) aufgenommen ist, verzögert, und eine Verbindungsöffnung (425) aufweist, die gestattet, dass das eingeleitete Wasser mit dem gespeicherten Wasser gemischt wird.

5. Kaltwasserbehälter nach Anspruch 1, wobei der Behälterhauptkörper (200) die Wassereinlasseinheit (230) und die Wasserauslasseinheit (240) umfasst und die Wassereinlasseinheit (230) einen Pufferraum (235) zum zeitweiligen Speichern von Wasser, das von außerhalb eingeleitet wird, bevor das Wasser durch den Wassereinlass (231) in den Behälterhauptkörper (200) eingeleitet wird, umfasst.

6. Kaltwasserbehälter nach Anspruch 5, wobei der Pufferraum (235) an einer Position, die von einer Position direkt über dem Wassereinlass (231), der in der Wassereinlasseinheit (230) vorgesehen ist, abweicht, mit einem Wassereinlassrohr (238) in Verbindung steht.

7. Wasserbehandlungsvorrichtung, umfassend:
den Kaltwasserbehälter (110) nach einem der Ansprüche 1 bis 6;
ein Wasserauslasselement, das Wasser, das in dem Kaltwasserbehälter (110) aufgenommen ist, abzieht; und
eine Energieversorgungseinrichtung (120), die elektrisch mit einer Kühleinheit (300) des Kaltwasserbehälters (110) verbunden ist,
wobei mindestens eine bestimmte Menge an Luft, die ein in der Kühleinheit (300) des Kaltwasserbehälters (110) vorgesehenes thermoelektrisches Modul (310) kühlt, zu der Energieversorgungseinrichtung (120) strömt, um die Energieversorgungseinrichtung (120) zu kühlen.

8. Wasserbehandlungsvorrichtung nach Anspruch 7, wobei die in dem Kaltwasserbehälter (110) vorgesehene Kühleinheit (300) Folgendes umfasst:
eine Wärmesenke (340), die mit der anderen Seite des thermoelektrischen Moduls (310) verbunden ist,
wobei die Energieversorgungseinrichtung (120) an einer Luftausströmseite der Wärmesenke (340) angeordnet ist, sodass sie direkt von Luft gekühlt wird, die aus der Wärmesenke (340) ausströmt.

9. Wasserbehandlungsvorrichtung nach Anspruch 8, wobei in die Wärmesenke (340) eingeleitete Luft aus beiden Seiten der Wärmesenke (340) ausströmt und die Energieversorgungseinrichtung (120) auf einer Seite der Wärmesenke (340) angeordnet ist.

10. Wärmebehandlungsvorrichtung nach Anspruch 9, wobei eine Mehrzahl von Lufteinström- / -ausströmlöchern (121), die gestatten, dass Luft dort hindurch ein- und ausströmt, an der Energieversorgungseinrichtung (120) ausgebildet sind und die Lufteinström- / -ausströmlöcher (121) der Energieversorgungseinrichtung (120) so angeordnet sind, dass sie einer Seite der Wärmesenke (340) zugewandt sind.

11. Wasserbehandlungsvorrichtung nach Anspruch 8, wobei eine Luftführungseinheit (310) zwischen der Wärmesenke (340) und der Energieversorgungseinrichtung (120) vorgesehen ist, um mindestens eine bestimmte Menge an Luft, die aus der Wärmesenke (340) ausströmt, so zu führen, dass sie zu der Energieversorgungseinrichtung (120) strömt und diese kühlt.

12. Wasserbehandlungsvorrichtung nach Anspruch 11, wobei eine Seite der Luftführungseinheit (310) an der Luftausströmseite der Wärmesenke (340) angeordnet ist und die andere Seite davon an der Energieversorgungseinrichtung (120) angeordnet ist.

13. Wasserbehandlungsvorrichtung nach Anspruch 12, wobei in die Wärmesenke (340) eingeleitete Luft aus beiden Seiten der Wärmesenke (340) ausströmt und eine Seite der Luftführungseinheit (310) auf einer Seite der Wärmesenke (340) angeordnet ist.

14. Wasserbehandlungsvorrichtung nach Anspruch 13, wobei die andere Seite der Luftführungseinheit an der Mehrzahl von Lufteinström- / -ausströmlöchern (121), die an der Energieversorgungseinrichtung (120) ausgebildet sind, angeordnet ist.

## Revendications

1. Réservoir d'eau froide comprenant :
un corps principal de réservoir (200) comprenant un premier corps (210) et un second corps (220) combinés pour former un espace interne à l'intérieur de celui-ci ; et
une unité de refroidissement (300) comprenant un module thermoélectrique (310) refroidissant de l'eau logée dans le corps principal de réservoir (200),
dans lequel le second corps (220) a une structure de revêtement dans laquelle des métaux hétérogènes sont joints, et l'intérieur du second corps (220) est en acier inoxydable et l'extérieur de celui-ci est en aluminium ou en cuivre, dans lequel le second corps (220)) a une forme arrondie ayant une partie centrale supérieure à celle de sa circonférence, et le module thermoélectrique (310) est connecté au second corps (220) pour refroidir le second corps (220), et
**caractérisé en ce que**
le premier corps (210) et le second corps (220) sont divisés dans une direction avant-arrière puis combinés pour former un espace interne à l'intérieur de celui-ci, et dans lequel
le premier corps (210) est constitué d'un matériau de résine synthétique et est formé pour être plus grand que le second corps (220).

2. Réservoir d'eau froide selon la revendication 1, dans lequel l'unité de refroidissement (300) comprend :
un dissipateur de froid (330) ayant un premier côté connecté à l'autre côté du second corps (220) et l'autre côté en contact avec un premier côté du module thermoélectrique (310) ; et
un dissipateur de chaleur (340) ayant un premier côté en contact avec l'autre côté du module thermoélectrique (310),
dans lequel un élément thermiquement conducteur (360) constitué d'un matériau métallique est installé sur un premier côté du second corps (220) et logé dans l'espace interne du corps principal de réservoir (200),
l'élément thermiquement conducteur (360) est fixé au second corps (220) par un élément de connexion (350) positionné sur un premier côté du second corps (220), et l'élément de connexion (350) connecte l'élément thermiquement conducteur (360), le second corps (220) et le dissipateur de froid (330).

3. Réservoir d'eau froide selon la revendication 1 ou la revendication 2, dans lequel l'unité de refroidissement (300) est fixée au second corps (220) par une pluralité d'éléments de fixation fixés au côté extérieur du second corps (220).

4. Réservoir d'eau froide selon la revendication 1, comprend en outre une unité de stabilisation d'eau introduite (400) prévue sur le corps principal de réservoir (200) pour empêcher de l'eau introduite ayant été introduite depuis une unité d'arrivée d'eau (230) formée sur le premier corps (210) d'être rapidement mélangée à de l'eau stockée logée dans le corps principal de réservoir (200),
dans lequel l'unité de stabilisation d'eau introduite (400) comprend :
une plaque retardatrice de mélange (410) retardant principalement un mélange de l'eau introduite ayant été introduite à partir l'unité d'arrivée d'eau (230) avec l'eau stockée déjà logée dans le corps principal de réservoir (200) ; et
un élément de séparation (420) retardant de manière secondaire un mélange d'eau qui passe à travers la plaque retardatrice de mélange avec l'eau stockée déjà logée dans le corps principal de réservoir (200) et ayant une ouverture de communication (425) permettant de mélanger l'eau introduite avec l'eau stockée.

5. Réservoir d'eau froide selon la revendication 1, dans lequel le corps principal de réservoir (200) comprend l'unité d'arrivée d'eau (230) et l'unité de sortie d'eau (240), et l'unité d'arrivée d'eau (230) comprend un espace tampon (235) stockant temporairement l'eau introduite depuis l'extérieur avant que l'eau ne soit introduite dans le corps principal de réservoir (200) à travers l'arrivée d'eau (231).

6. Réservoir d'eau froide de la revendication 5, dans lequel l'espace tampon (235) communique avec un tuyau d'arrivée d'eau (238) au niveau d'une position qui s'écarte de la position directement au-dessus de l'arrivée d'eau (231) prévue dans l'unité d'arrivée d'eau (230).

7. Appareil de traitement d'eau comprenant :
le réservoir d'eau froide (110) selon l'une quelconque des revendications 1 à 6 ;
un élément de sortie d'eau extrayant de l'eau logée dans le réservoir d'eau froide (110) ; et
un dispositif d'alimentation électrique (120) connecté électriquement à une unité de refroidissement (300) du réservoir d'eau froide (110),
dans lequel au moins une certaine quantité d'air qui refroidit un module thermoélectrique (310) prévu dans l'unité de refroidissement (300) du réservoir d'eau froide (110) s'écoule vers le dispositif d'alimentation électrique (120) pour refroidir le dispositif d'alimentation électrique (120).

8. Appareil de traitement d'eau selon la revendication 7, dans lequel l'unité de refroidissement (300) prévue dans le réservoir d'eau froide (110) comprend :
un dissipateur de chaleur (340) connecté à l'autre côté du module thermoélectrique (310),
dans lequel le dispositif d'alimentation électrique (120) est positionné d'un côté d'écoulement de sortie d'air du dissipateur de chaleur (340) de manière à être directement refroidi par de l'air s'écoulant à l'extérieur du dissipateur de chaleur (340).

9. Appareil de traitement d'eau selon la revendication 8, dans lequel de l'air introduit dans le dissipateur de chaleur (340) s'écoule vers l'extérieur depuis les deux côtés du dissipateur de chaleur (340), et le dispositif d'alimentation électrique (120) est positionné de part et d'autre du dissipateur de chaleur (340).

10. Appareil de traitement d'eau selon la revendication 9, dans lequel une pluralité de trous d'écoulement entrant/écoulement sortant d'air (121) permettant à de l'air de s'écouler vers l'intérieur et vers l'extérieur à travers ceux-ci sont formés sur le dispositif d'alimentation électrique (120), et les trous d'écoulement entrant/écoulement sortant d'air (121) du dispositif d'alimentation électrique (120) sont positionnés pour faire face à l'un ou l'autre côté du dissipateur de chaleur (340).

11. Appareil de traitement d'eau selon la revendication 8, dans lequel une unité de guidage d'air (310) est prévue entre le dissipateur de chaleur (340) et le dispositif d'alimentation électrique (120) pour guider au moins une certaine quantité d'air s'écoulant à l'extérieur du dissipateur de chaleur (340) pour s'écouler vers et refroidir le dispositif d'alimentation électrique (120).

12. Appareil de traitement d'eau selon la revendication 11, dans lequel un premier côté de l'unité de guidage d'air (310) est positionné sur le côté d'écoulement de sortie d'air du dissipateur de chaleur (340), et l'autre côté de celui-ci est positionné au niveau du dispositif d'alimentation électrique (120).

13. Appareil de traitement d'eau selon la revendication 12, dans lequel de l'air introduit dans le dissipateur de chaleur (340) s'écoule vers l'extérieur depuis les deux côtés du dissipateur de chaleur (340), et un premier côté de l'unité de guidage d'air (310) est positionné d'un côté ou de l'autre du dissipateur de chaleur (340).

14. Appareil de traitement d'eau selon la revendication 13, dans lequel l'autre côté de l'unité de guidage d'air est positionné au niveau de la pluralité de trous d'écoulement entrant/écoulement sortant d'air (121) formés sur le dispositif d'alimentation électrique (120).
